# EUROPEAN PATENT SPECIFICATION

(11) **EP 1 953 498 B1**
(45) Date of publication and mention of the grant of the patent: **29.08.2012**
(21) Application number: 06823473.1
(22) Date of filing: 20.11.2006
(51) Int. Cl.: G01C 19/5663, G01C 19/5628, H01L 41/22

(54) **OSCILLATOR AND METHOD FOR MANUFACTURING THE SAME**
OSZILLATOR UND VERFAHREN ZU SEINER HERSTELLUNG
OSCILLATEUR ET SON PROCEDE DE FABRICATION

(30) Priority: 21.11.2005 JP 2005335439; 17.11.2006 JP 2006310882
(43) Date of publication of application: 06.08.2008
(73) Proprietor: MURATA MANUFACTURING CO., LTD., Nagaokakyo-shi, Kyoto 617-8555 (JP)
(72) Inventor: FUJIMOTO, Katsumi, Nagaokakyo-shi, Kyoto 6178555 (JP)
(74) Representative: Schoppe, Fritz
(86) International application number: PCT/JP2006/323086
(87) International publication number: WO 2007/058343

(56) References cited:
- JP-A- 8 189 833
- JP-A- 03 096 807
- JP-A- 08 068 638
- JP-A- 08 178 666
- JP-A- 11 094 555
- JP-A- 2000 314 629
- JP-A- 2001 021 359
- JP-A- 2005 181 271
- US-A- 5 942 839

## Description

### Technical Field

The present invention relates to a vibrator and a production method therefor, and more particularly, to a vibrator for use in, for example, a piezoelectric vibrating gyroscope for detecting the angular velocity and a production method therefor.

### Background Art

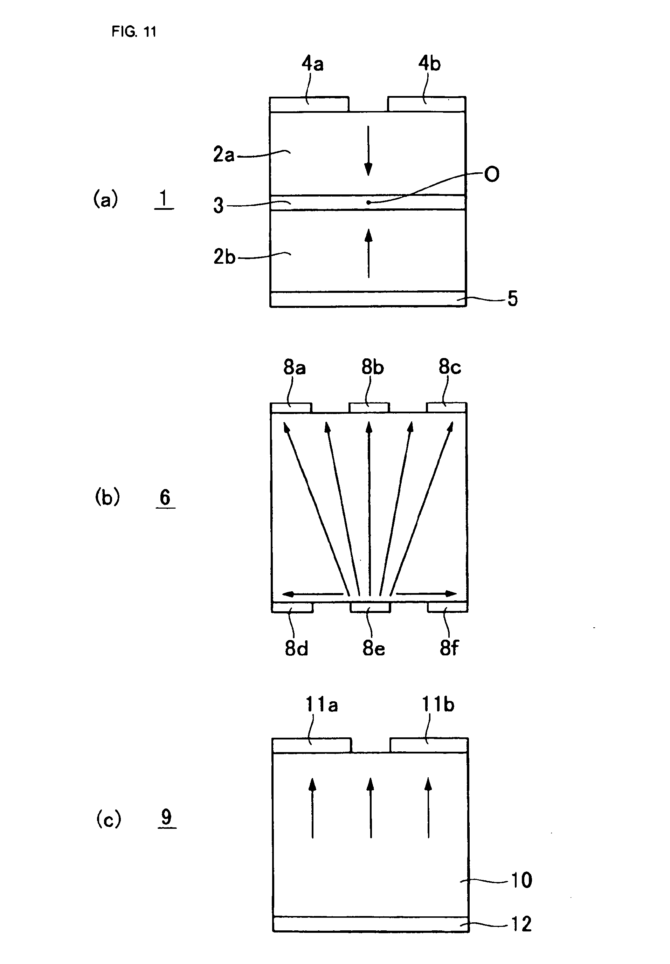

FIG. 11 includes cross-sectional views of known vibrators serving as the background of the present invention.

As shown in FIG. 11 (a), a vibrator 1 includes, for example, a first piezoelectric substrate 2a and a second piezoelectric substrate 2b. The first piezoelectric substrate 2a and the second piezoelectric substrate 2b are stacked with a joint layer 3 disposed therebetween. Further, the first piezoelectric substrate 2a and the second piezoelectric substrate 2b are polarized in opposite thickness directions, as shown by the arrows in FIG. 11 (a). Two split electrodes 4a and 4b are provided on a principal surface of the first piezoelectric substrate 2a such as to be spaced from each other in the width direction. A common electrode 5 is provided on a principal surface of the second piezoelectric substrate 2b (see Patent Document 1).

For example, the vibrator 1 is used in a piezoelectric vibrating gyroscope for detecting the angular velocity. A driving signal, such as a sinusoidal signal, is applied to the split electrodes 4a and 4b and the common electrode 5 in the vibrator 1. By the driving signal, the first piezoelectric substrate 2a and the second piezoelectric substrate 2b are displaced in opposite directions. In this case, when the first piezoelectric substrate 2a expands parallel to the principal surface thereof, the second piezoelectric substrate 2b contracts parallel to the principal surface thereof. Conversely, when the first piezoelectric substrate 2a contracts parallel to the principal surface thereof, the second piezoelectric substrate 2b expands parallel to the principal surface thereof. For this reason, the first piezoelectric substrate 2a and the second piezoelectric substrate 2b bend in a direction orthogonal to the principal surfaces thereof. When the vibrator 1 is rotated about a center axis O in this state, since different signals are output from the two split electrodes 4a and 4b, a signal corresponding to the angular velocity of rotation can be detected by finding a difference between the output signals from the two split electrodes 4a and 4b. The angular velocity of rotation can be known from the output signal.

For this vibrator 1, a step of joining the two substrates is performed. The joining step impairs the production efficiency in mass production, and also causes variations in the characteristic among vibrators. When the joint layer 3 is formed of an organic adhesive such as an epoxy adhesive, the adhesive also vibrates during excitation of the vibrator 1. Consequently, the efficiency of detection of the angular velocity is reduced. Moreover, the vibration state changes with the change of the adhesive due to the temperature, and the sensitivity of detection of the angular velocity varies.

Accordingly, a vibrator 6 shown in FIG. 11 (b) is disclosed as a vibrator having no joint layer.

In the vibrator 6, electrodes 8a, 8b, 8c and electrodes 8d, 8e, and 8f are provided on opposite faces of a vibrating body 7 shaped like a quadrangular prism. The vibrating body 7 is polarized from the electrode 8e toward the electrodes 8a, 8b, and 8c, and is also polarized from the electrode 8e toward the electrodes 8d and 8f (see Patent Document 2).

A vibrator 8 shown in FIG. 11 (c) is also disclosed as another vibrator having no joint layer.

The vibrator 9 includes a vibrating body 10, for example, shaped like a quadrangular prism, and two split electrodes 11a and 11b are provided on one principal surface such as to extend in the longitudinal direction and to be spaced from each other in the width direction. A common electrode 12 is provided on the entirety of a principal surface of the vibrating body 10 opposite to the surface on which the split electrodes 11a and 11b are provided. The vibrating body 10 is strongly polarized toward the split electrodes 11 and 11b on a side close to the surface having the split electrodes 11a and 11b, and is weakly polarized on a side close to the common electrode 12. This is attained by heating one side of the vibrating body 10, which has been polarized in the thickness direction beforehand, to a temperature higher than or equal to the Curie point so as to weaken polarization, and by cooling the other side so as to maintain polarization (see Patent Document 3).

Since the above-described vibrators 6 and 9 do not have a joint layer, the problems of the related art resulting from the joint layer are not caused.
Patent Document 1: Japanese Patent Application Publication No. H7-332988
Patent Document 2: Japanese Patent Application Publication No. H11-83496
Patent Document 3: Japanese Patent Application Publication No. 2000-314629

As described above, in the joint-type vibrator 1, since the joint step of joining the first piezoelectric substrate 2a and the second piezoelectric substrate 2b is performed, it reduces production efficiency in mass production.

The vibrator 6 has a problem in that the electromechanical coefficient thereof is lower than that of the joint-type vibrator 1. While the unimorph vibrator 9 has an electromechanical coefficient higher than that of the vibrator 6 in which the polarizing direction of a part is changed, only one side of the vibrating body 10 in the thickness direction is displaced by the driving signal, and therefore, the obtained electromechanical coefficient is less than or equal to half the electromechanical coefficient of the joint-type vibrator 1.

In this way, the joint-type vibrator has a problem in production efficiency, and the vibrator having no joint layer has a problem in that the electromechanical coefficient is low, that is, the exchange efficiency between electrical energy and mechanical energy is low.

US 5, 942, 839 A describes a piezoelectric vibrator having three parallel vibrator arms formed from piezoelectric material in which dielectric polarization is generated through the application of electric fields extending widthwise between first electrodes formed on top surfaces thereof and between second electrodes formed on bottom surfaces, and also between the first and second electrodes through the piezoelectric material, such that a portion of the dielectric polarization occurs at the surfaces of the vibrator arms, and a portion also occurs within the vibrator arms.

JP 2001-021359 A describes an oscillator constituted of a piezoelectric body shaped like a square pole, and a first divided electrode and a second divided electrode are formed on a first die face, and a third divided electrode and a fourth divided electrode are formed on a second side face.

### SUMMARY OF THE INVENTION

It is an obj ect of the present invention to provide a vibrator that achieves high production efficiency and provides a high electromechanical coefficient, and a production method for the vibrator.

This object is achieved by a vibrator of claim 1 or 2, by a vibrator assembly of claim 3 or 4, and by a method of one of claims 5 to 10.

A vibrator according to the present invention includes a vibrating body shaped like a quadrangular prism and having four side faces extending in a longitudinal direction; a common electrode provided on the entirety of one of the side faces of the vibrating body; and split electrodes provided on the side face opposite to the side face on which the common electrode is provided, the split electrodes being spaced in a width direction. The vibrating body includes a first polarized section polarized in a direction from the side faces having no electrode toward the split electrodes, and a second polarized section polarized in a direction from the side faces having no electrode toward the common electrode.

A vibrator according to the present invention includes a vibrating body shaped like a quadrangular prism and having four side faces extending in a longitudinal direction; a common electrode provided on the entirety of one of the side faces of the vibrating body; and split electrodes provided on the side face opposite to the side face on which the common electrode is provided, the split electrodes being spaced in a width direction. The vibrating body includes a first polarized section polarized in a direction from the side faces having no electrode toward the split electrodes, and a second polarized section polarized in a direction from the split electrodes toward the common electrode in a portion other than the first polarized section.

The above-described vibrator is polarized substantially oppositely in the thickness direction of the vibrating body having no joint layer. Therefore, opposite displacements are produced in the thickness direction of the vibrating body by applying a driving signal to the split electrodes and the common electrode of the vibrating body.

A tuning-fork vibrator assembly according to the present invention includes two vibrators claimed in claim 1 or 2 that are arranged side by side and are connected by a connecting portion. The two vibrators are connected so that the split electrodes are provided on the same plane. The connecting portion is connected over an appropriate width to one-end portions of the two vibrators.

An H-type vibrator assembly according to the present invention includes two vibrators claimed in claim 1 or 2 that are arranged side by side and are connected by a connecting portion. The two vibrators are connected so that the split electrodes are provided on the same plane. The connecting portion is connected over an appropriate width to almost the centers of the two vibrators.

A vibrator production method according to the present invention includes a first step of forming an electrode on each of one principal surface and the other principal surface of a substrate; a second step of forming grooves at regular intervals in the one principal surface and the other principal surface of the substrate; a third step of forming electrodes in the grooves; a fourth step of forming additional grooves in the grooves, the additional grooves being shallower and wider than the grooves; a fifth step of applying a voltage between the electrodes formed in the grooves of the one principal surface and the electrode formed on the one principal surface, and between the electrodes formed in the grooves of the other principal surface and the electrode formed on the other principal surface so as to produce polarization from the electrodes formed in the grooves of the one principal surface toward the one principal surface and to produce polarization from the electrodes formed in the grooves of the other principal surface toward the other principal surface; a sixth step of forming split electrodes on the one principal surface; and a seventh step of cutting the substrate at the grooves.

According to this vibrator production method, a plurality of vibrators having the above-described configuration can be simultaneously obtained from a single substrate.

Another vibrator production method according to the present invention includes a first step of forming an electrode on each of one principal surface and the other principal surface of a substrate; a second step of polarizing the substrate from the one principal surface toward the other principal surface; a third step of forming grooves at regular intervals in the one principal surface of the substrate; a fourth step of forming electrodes in the grooves; a fifth step of forming additional grooves in the grooves, the additional grooves being shallower and wider than the grooves; a sixth step of applying a voltage between the electrodes formed in the grooves and the electrode formed on the one principal surface so as to produce polarization from the electrodes formed in the grooves toward the one principal surface; a seventh step of forming split electrodes on the one principal surface; and an eighth step of cutting the substrate at the grooves.

According to this vibrator production method, a plurality of vibrators having the above-described configuration can be simultaneously obtained from a single substrate. Moreover, when the grooves are formed at regular intervals in the one principal surface of the substrate, the ratio of a section in which polarization is reversed can be adjusted by adjusting the depth of the grooves.

Atuning-fork vibrator assembly production method according to the present invention includes a first step of forming an electrode on each of one principal surface and the other principal surface of a substrate; a second step of forming grooves at regular intervals in the one principal surface and the other principal surface of the substrate; a third step of forming electrodes in the grooves; a fourth step of forming additional grooves in the grooves, the additional grooves being shallower and wider than the grooves; a fifth step of applying a voltage between the electrodes formed in the grooves of the one principal surface and the electrode formed on the one principal surface, and between the electrodes formed in the grooves of the other principal surface and the electrode formed on the other principal surface so as to produce polarization from the electrodes formed in the grooves of the one principal surface toward the one principal surface and to produce polarization from the electrodes formed in the grooves of the other principal surface toward the other principal surface; a sixth step of forming split electrodes on the one principal surface; a seventh step of cutting the substrate at every other groove so as to form substrate pieces; and an eighth step of cutting each of the substrate pieces at the groove with one-end portion thereof being left so that two vibrators and a connecting portion for connecting one-end portions of the two vibrators are formed.

Another tuning-fork vibrator assembly production method according to the present invention includes a first step of forming an electrode on each of one principal surface and the other principal surface of a substrate; a second step of polarizing the substrate from the one principal surface toward the other principal surface; a third step of forming grooves at regular intervals in the one principal surface of the substrate; a fourth step of forming electrodes in the grooves; a fifth step of forming additional grooves in the grooves, the additional grooves being shallower and wider than the grooves; a sixth step of applying a voltage between the electrodes formed in the grooves of the one principal surface and the electrode formed on the one principal surface so as to produce polarization from the electrodes formed in the grooves toward the one principal surface; a seventh step of forming split electrodes on the one principal surface; an eighth step of cutting the substrate at every other groove so as to form substrate pieces; and a ninth step of cutting each of the substrate pieces at the groove with one-end portion thereof being left so that two vibrators and a connecting portion for connecting one-end portions of the two vibrators are formed.

An H-type vibrator assembly production method according to the present invention includes a first step of forming an electrode on each of one principal surface and the other principal surface of a substrate; a second step of forming grooves at regular intervals in the one principal surface and the other principal surface of the substrate; a third step of forming electrodes in the grooves; a fourth step of forming additional grooves in the grooves, the additional grooves being shallower and wider than the grooves; a fifth step of applying a voltage between the electrodes formed in the grooves of the one principal surface and the electrode formed on the one principal surface, and between the electrodes formed in the grooves of the other principal surface and the electrode formed on the other principal surface so as to produce polarization from the electrodes formed in the grooves of the one principal surface toward the one principal surface and to produce polarization from the electrodes formed in the grooves of the other principal surface toward the other principal surface; a sixth step of forming split electrodes on the one principal surface; a seventh step of cutting the substrate at every other groove so as to form substrate pieces; and an eighth step of cutting each of the substrate pieces at the groove with a center portion thereof being left so that two vibrators and a connecting portion for connecting the centers of the two vibrators are formed.

Another H-type vibrator assembly production method according to the present invention includes a first step of forming an electrode on each of one principal surface and the other principal surface of a substrate; a second step of polarizing the substrate from the one principal surface toward the other principal surface; a third step of forming grooves at regular intervals in the one principal surface of the substrate; a fourth step of forming electrodes in the grooves; a fifth step of forming additional grooves in the grooves, the additional grooves being shallower and wider than the grooves; a sixth step of applying a voltage between the electrodes formed in the grooves of the one principal surface and the electrode formed on the one principal surface so as to produce polarization from the electrodes formed in the grooves toward the one principal surface; a seventh step of forming split electrodes on the one principal surface; an eighth step of cutting the substrate at every other groove so as to form substrate pieces; and a ninth step of cutting each of the substrate pieces at the groove with a center portion thereof being left so that two vibrators and a connecting portion for connecting the centers of the two vibrators are formed.

### Advantages of the Invention

According to the present invention, since the vibrating body does not have a joint layer, a step of joining two piezoelectric substrates, as in the related art, is unnecessary. This can rationalize the production process and can reduce the cost.

The vibrator according to the present invention includes sections polarized in opposite directions on both sides of the single vibrating body in the thickness direction. Therefore, displacements in opposite directions are caused on both sides of the vibrating body in the thickness direction by applying a driving signal to the split electrodes and the common electrode. As a result, the electromechanical coefficient is increased.

Further, since the vibrator according to the present invention does not have a joint layer, the state of the dielectric layer is not caused by the temperature change, and the decrease in detection sensitivity due to the change is limited.

According to the production method of the present invention, the use of the electrodes provided in the grooves allows sections polarized in different directions to be respectively formed on both sides of the single vibrating body in the thickness direction.

Therefore, a plurality of vibrators having the configuration according to the present invention can be obtained from a single substrate.

Further, according to the production method of the present invention, vibrators, such as a tuning-fork vibrator and an H-type vibrator, can be easily produced by applying the above-described vibrator production method.

The above-described object, otherobjects, characteristics, and advantages of the present invention will become apparent from the following description of the best mode for carrying out the invention with reference to the drawings.

### Brief Description of the Drawings

[FIG. 1] FIG. 1 is a perspective view illustrating a vibrator according to the present invention.

[FIG. 2] FIG. 2 includes explanatory views showing a production method for producing the vibrator according to the present invention.

[FIG. 3] FIG. 3 is a perspective view illustrating another vibrator according to the present invention.

[FIG. 4] FIG. 4 includes explanatory views showing a production method for producing the vibrator according to the present invention.

[FIG. 5] FIG. 5 is a perspective view illustrating a tuning-fork vibrator assembly according to the present invention.

[FIG. 6] FIG. 6 is an explanatory view showing a production method for producing the tuning-fork vibrator assembly according to the present invention.

[FIG. 7] FIG. 7 is a perspective view of another tuning-fork vibrator assembly according to the present invention.

[FIG. 8] FIG. 8 is an explanatory view showing a production method for producing the tuning-fork vibrator assembly according to the present invention.

[FIG. 9] FIG. 9 is a perspective view illustrating an H-type vibrator assembly according to the present invention.

[FIG. 10] FIG. 10 is a perspective view illustrating another H-type vibrator assembly according to the present invention.

[FIG. 11] FIG. 11 includes cross-sectional views illustrating known vibrators serving as the background of the present invention.

### Reference Numerals

20, 50: vibrator
22a, 22b, 22c, and 22d: side face
24: vibrating body
26: common electrode
28a, 28b: split electrode
30: first polarized section
32: second polarized section
34: substrate
36, 38: full-face electrode
40a, 40b: first groove
42a, 42b: electrode
44a, 44b: second groove
60: connecting portion
120, 150: tuning-fork vibrator assembly
220, 250: H-type vibrator assembly

### Best Mode for Carrying Out the Invention

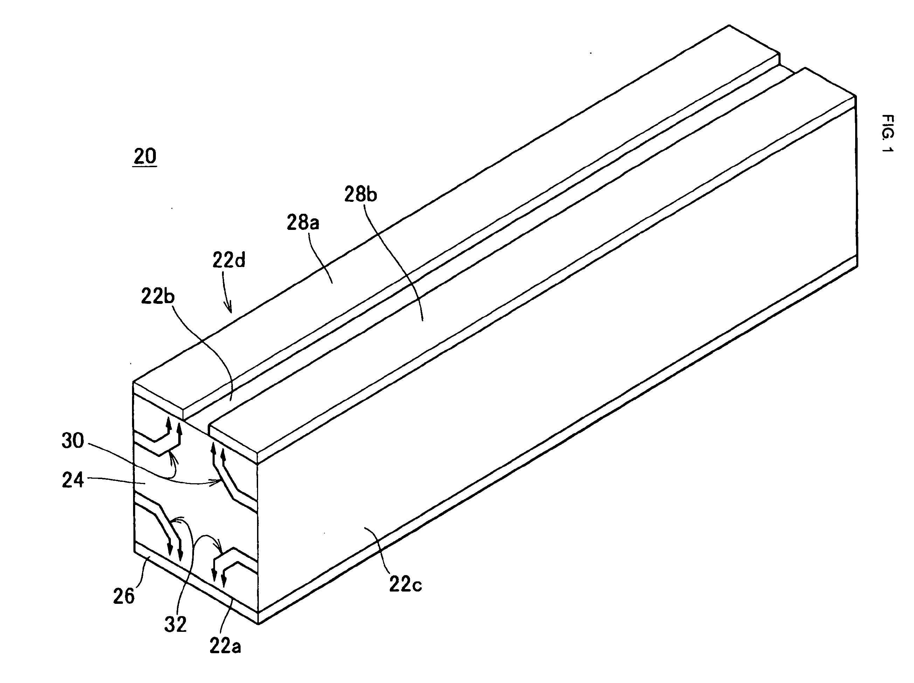

FIG. 1 is a perspective view illustrating a vibrator according to an embodiment of the present invention.

A vibrator 20 includes a vibrating body 24 shaped like a quadrangular prism, and having four side faces 22a, 22b, 22c, and 22d that extend in the longitudinal direction. A common electrode 26 is provided on the entirety of the side face 22a of the vibrating body 24. Split electrodes 28a and 28b extend in the longitudinal direction on the side face 22b opposite to the side face 22a having the common electrode 26, and are spaced at the widthwise center of the side face 22b.

The vibrating body 24 includes a first polarized section 30 and a second polarized section 32. The first polarized section 30 is formed so as to be polarized from the side faces 22c and 22d of the vibrating body 24, on which an electrode is not provided, toward the side face 22b on which the split electrodes 28a and 28b are provided. The second polarized section 32 is formed so as to be polarized from the side faces 22c and 22d of the vibrating body 24, on which an electrode is not provided, toward the side face 22a on which the common electrode 26 is provided.

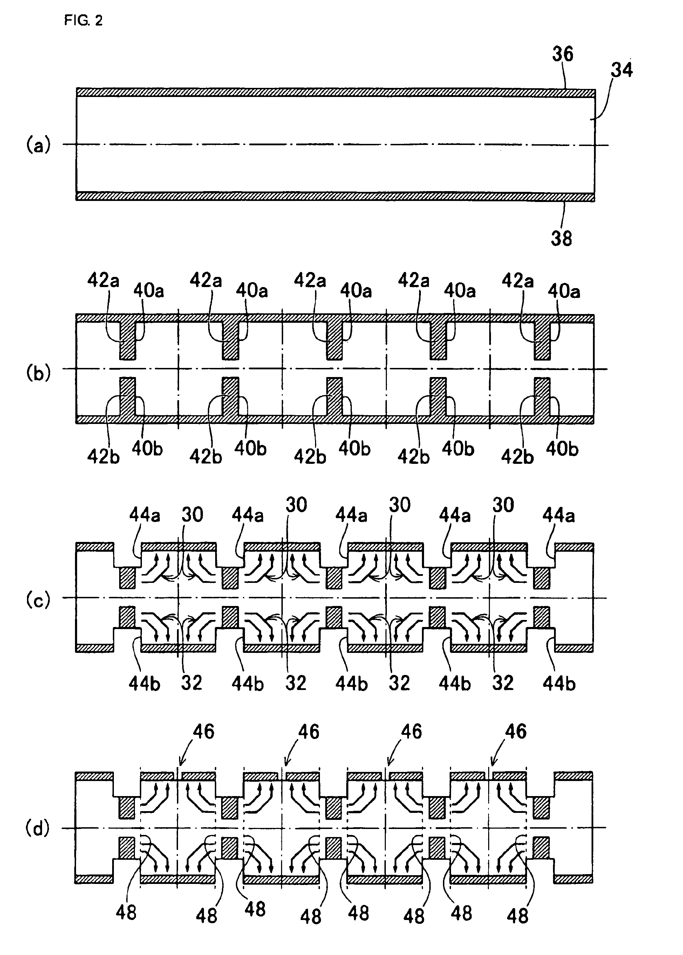

FIG. 2 includes cross-sectional views illustrating a production method for the vibrator 20.

In order to produce this vibrator 20, a substrate 34 is first prepared.

Full-face electrodes 36 and 38 are respectively formed on one principal surface and the other principal surface of the substrate 34, as shown in FIG. 2(a).

As shown in FIG. 2(b), first grooves 40a and 40b are respectively formed in parallel and at regular intervals in the one principal surface and the other principal surface of the substrate 34. The first grooves 40a and 40b oppose each other. Electrodes 42a and 42b are respectively formed in the first grooves 40a and 40b provided in the one principal surface and the other principal surface of the substrate 34. As a result, the full-face electrodes 36 and 38 are connected to the electrodes 42a and 42b. While the first grooves 40a and 40b are completely filled with the electrodes 42a and 42b with no clearance in FIG. 2(b), it is satisfactory as long as the electrodes 42a and 42b are entirely in contact with side faces and bottom faces of the first grooves 40a and 40b.

As shown in FIG. 2(c), second grooves 44a and 44b wider and shallower than the first grooves 40a and 40b are formed at the electrodes 42a and 42b provided in the first grooves 40a and 40b. As a result, the full-face electrodes 36 and 38 are separated from the electrodes 42a and 42b.

By applying a voltage between the electrodes 42a formed in the first grooves 40a of the one principal surface of the substrate 34 and the full-face electrode 36 formed on the one principal surface, and between the electrodes 42b formed in the first grooves 40b of the other principal surface of the substrate 34 and the full-face electrode 38 formed on the other principal surface, first polarized sections 30 and second polarized sections 32 are formed in opposite thickness directions, as shown by the arrows in FIG. 2(c).

In FIG. 2(d), split electrodes 28a and 28b are formed by cutting portions of the full-face electrode 36 on the one principal surface of the substrate 34 along center lines 46 between the grooves 44a. Subsequently, the substrate 34 is cut along the second wide grooves 44a and 44b, as shown by dotted lines 48 in FIG. 2(d), so that a plurality of vibrators 20 are formed. In this case, the electrodes 42a and 42b in the first grooves 40a and 40b are removed.

Since this vibrator 20 does not have a joint layer, a step of bonding the substrates via the joint layer is unnecessary. This can rationalize the production process and can reduce the cost. Further, since the vibrator 20 includes the vibrating body 24 polarized in opposite thickness directions, it generates bimorph vibration by the application of a driving signal to the split electrodes 28a and 28b and the common electrode 26. Therefore, the vibrator 20 having a high electromechanical coefficient can be obtained.

According to the above-described production method for the vibrator 20, by applying a voltage between the electrodes 42a formed in the first grooves 40a and the full-face electrode 36, and between the electrodes 42b formed in the first grooves 40b and the full-face electrode 38, the first polarized section 30 and the second polarized section 32 polarized in different directions can be formed so that the first polarized section 30 lies on one side of the single vibrating body 24 in the thickness direction and the second polarized section 32 lies on the other side. Moreover, many vibrators 20 can be simultaneously obtained from a single plate.

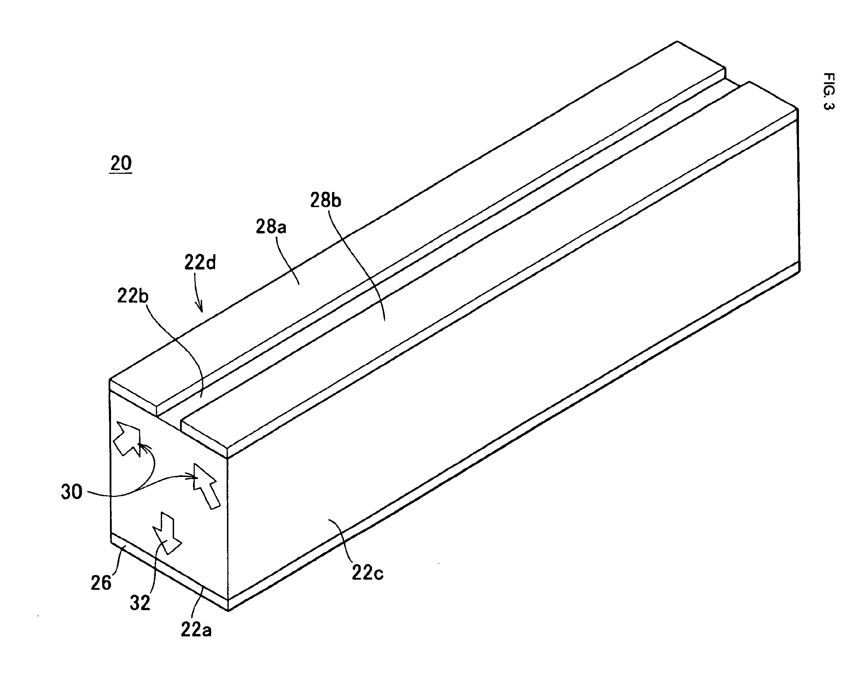

FIG. 3 is a perspective view illustrating a vibrator according to another embodiment of the present invention.

A vibrator 50 includes a vibrating body 24 shaped like a quadrangular prism and having four side faces 22a, 22b, 22c, and 22d extending in the longitudinal direction. A common electrode 26 is provided on the entirety of the side face 22a of the vibrating body 24. Split electrodes 28a and 28b extend in the longitudinal direction on the side face 22b opposite to the side face 22a on which the common electrode 26 is provided, and are spaced at the widthwise center of the side face 22b.

The vibrating body 24 includes a first polarized section 30 and a second polarized section 32. The first polarized section 30 is formed such as to be polarized from the side faces 22c and 22d of the vibrating body 24, on which an electrode is not provided, toward the side face 22b on which the split electrodes 28a and 28b are provided. The second polarized section 32 is formed in a portion of the vibrating body 24 other than the first polarized section 30, and is polarized from the side face 22b having the split electrodes 28a and 28b toward the side face 22a on which the common electrode 26 is provided.

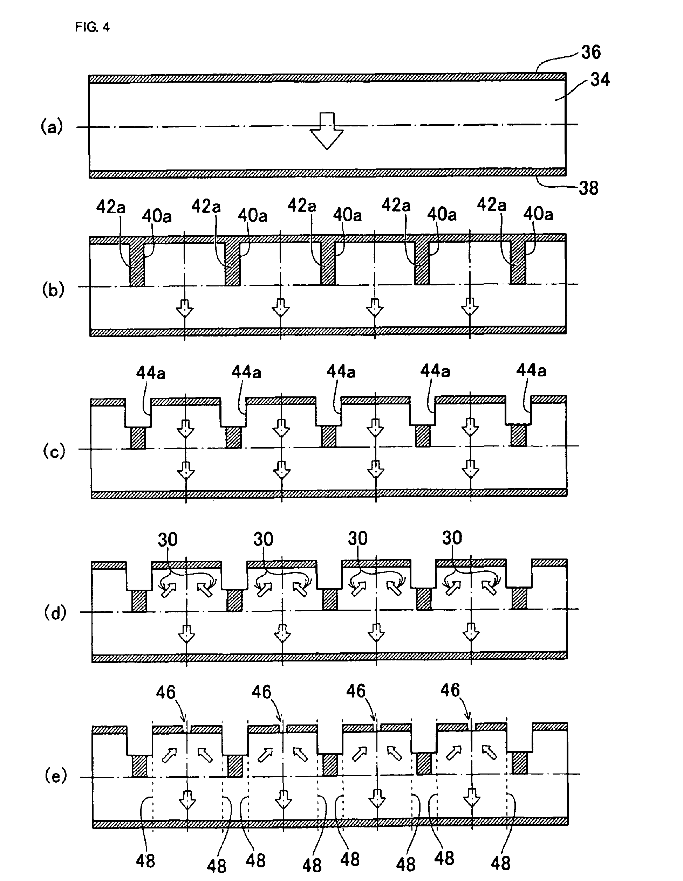

FIG. 4 includes cross-sectional views illustrating a production method for the vibrator 50.

In order to produce this vibrator 50, a substrate 34 is first prepared.

As shown in FIG. 4 (a), full-face electrodes 36 and 38 are respectively formed on one principal surface and the other principal surface of the substrate 34. As shown by the arrow in FIG. 4(a), the substrate 34 is polarized entirely in the thickness direction, that is, from the one principal surface to the other principal surface of the substrate 34.

First grooves 40a are formed at regular intervals and in parallel in the one principal surface of the substrate 34, as shown in FIG. 4 (b). Electrodes 42a are formed in the first grooves 40a formed in the one principal surface of the substrate 34. As a result, the full-face electrode 36 is connected to the electrodes 42a. While the first grooves 40a are completely filled with the electrodes 42a with no clearance in FIG. 4(b), it is satisfactory as long as the electrodes 42a are entirely in contact with side and bottom faces of the first grooves 40a.

Subsequently, as shown in FIG. 4(c), second grooves 44a wider and shallower than the first grooves 40a formed in the one principal surface of the substrate 34 are formed at the electrodes 42a provided in the first grooves 40a. As a result, the full-face electrode 36 is separated from the electrodes 42a.

First polarized sections 30 are formed by applying a voltage between the electrodes 42a provided in the first grooves 40a of the one principal surface of the substrate 34 and the full-face electrode 36 on the one principal surface, as shown by the arrows in FIG. 4(d). The polarization of the substrate 34 remains in a portion of the substrate 34 other than the first polarized sections 30, thereby forming second polarized sections 32.

In FIG. 4(e), split electrodes 28a and 28b are formed by cutting portions of the full-face electrode 36 on the one principal surface of the substrate 34 along center lines 46 between the grooves 44a. Subsequently, as shown by dotted lines 48 in FIG. 4 (e), the substrate 34 is cut along the wide second grooves 44a and 44b, so that a plurality of vibrators 50 are formed. In this case, the electrodes 42a in the first grooves 40a are removed.

Since this vibrator 50 does not have a joint layer either, a step of bonding the substrates via the joint layer is unnecessary. This can rationalize the production process and can reduce the cost. Further, since the vibrator 50 includes the vibrating body 24 polarized in opposite thickness directions, it generates bimorph vibration by the application of a driving signal to the split electrodes 28a and 28b and the common electrode 26. Therefore, the vibrator 50 having a high electromechanical coefficient can be obtained.

Further, according to the above-described production method for the vibrator 50, after polarization is performed in the thickness direction of the vibrating body 24 by applying a voltage between the full-face electrode 36 and the full-face electrode 38, a voltage is applied between the electrodes 42a provided in the first grooves 40a and the full-face electrode 36. Consequently, the first polarized section 30 and the second polarized section 32 polarized in different directions can be formed so that the first polarized section 30 lies on one side of the single vibrating body 24 in the thickness direction and the second polarized section 32 lies on the other side.

According to the production method for the vibrator 50, the range of the first polarized section 30 can be controlled by adjusting the depth of the first groove 40a, and the bimorph vibration state of the vibrator can be thereby controlled. Moreover, many vibrators 50 can be simultaneously obtained from a single plate.

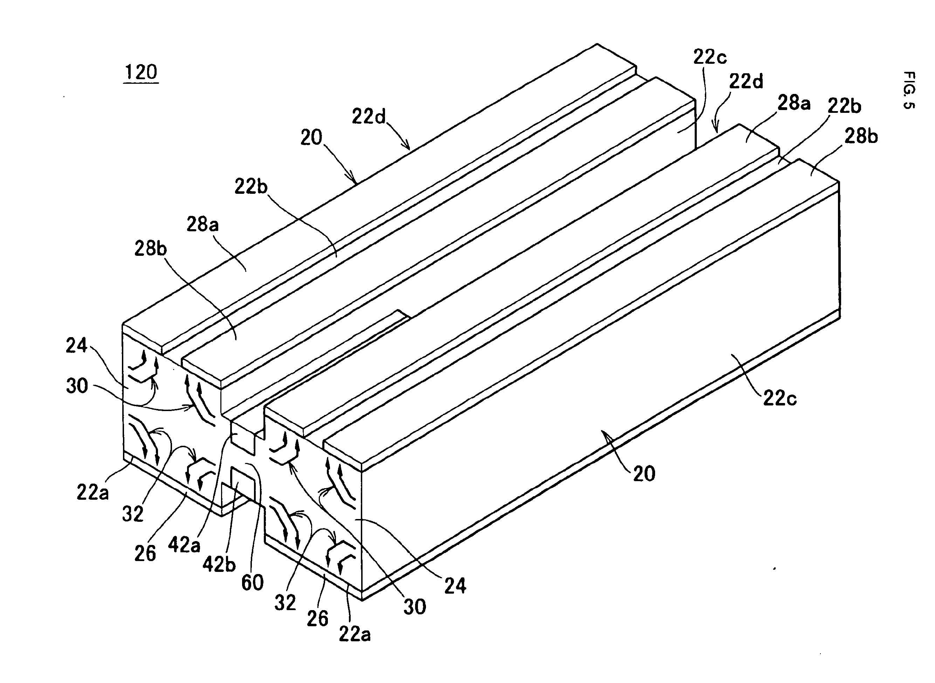

FIG. 5 is a perspective view illustrating a tuning-fork vibrator assembly according to an embodiment of the present invention.

A tuning-fork vibrator assembly 120 includes two vibrators 20 arranged side by side. These vibrators 20 are connected at one end by a connecting portion 60 so as to form a tuning fork as a whole. The two vibrators 20 have a structure similar to that of the vibrator 20 shown in FIG. 1, and the connecting portion 60 is formed of the same material as that of the vibrating body 24 that constitutes the vibrator 20. Electrodes 42a and 42b are provided in opposite portions of the connecting portion 60, and extend along the two vibrators 20. These electrodes 42a and 42b are left in a production process for the tuning-fork vibrator assembly 120, and are not pertinent to the operation of the tuning-fork vibrator assembly 120.

A description will now be given of a production method for producing the tuning-fork vibrator assembly 120.

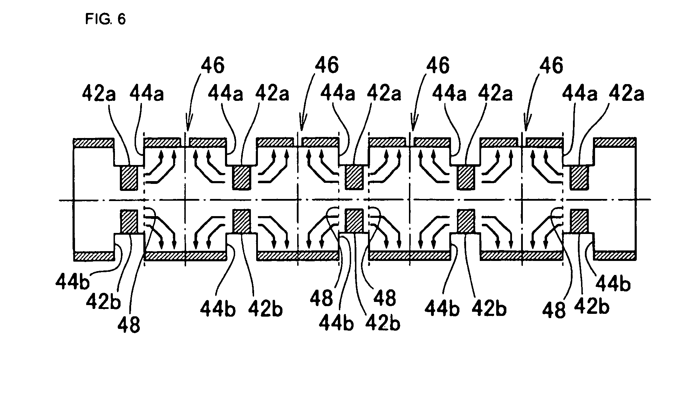

The production method for the tuning-fork vibrator assembly 120 includes the steps shown in FIGS. 2(a) to 2(d), and a polarized substrate 34 is formed. Then, as shown in FIG. 6, split electrodes 28a and 28b are formed by cutting portions of a full-face electrode on one principal surface of the substrate 34 along center lines 46 between grooves 44a in the full-face electrode. Subsequently, as shown by dotted lines 48 in FIG. 6, the substrate 34 is cut at every other groove, so that a plurality of substrate pieces each having a center groove are formed. Each substrate piece thus obtained is cut at the groove so as to leave the portion located at one end side of the substrate. Consequently, two vibrators 20 and a connecting portion 60 are formed, and a tuning-fork vibrator assembly 120 can be obtained thereby.

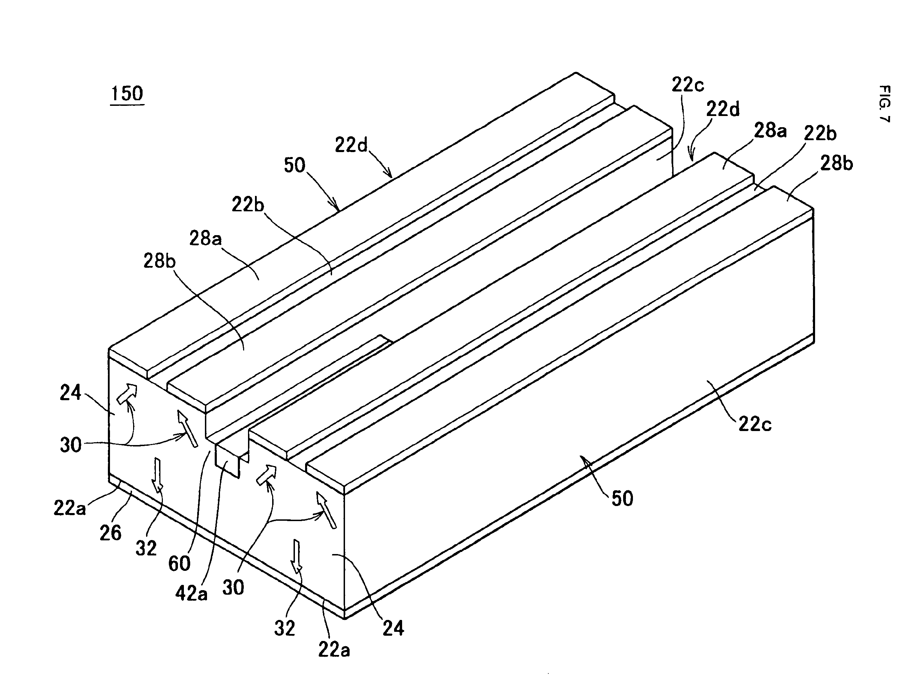

FIG. 7 is a perspective view illustrating a tuning-fork vibrator assembly according to another embodiment of the present invention.

A tuning-fork vibrator assembly 150 includes two vibrators 50 arranged side by side. These vibrators 50 are connected at one end by a connecting portion 60 so as to form a tuning fork as a whole. The two vibrators 50 have a structure similar to that of the vibrator 50 shown in FIG. 3, and the connecting portion 60 is formed of the same material as that of the vibrating body 24 that constitutes the vibrator 50. An electrode 42a is provided in opposite portions of the connecting portion 60, and extends along the two vibrators 50. The electrode 42a is left in a production process for the tuning-fork vibrator assembly 150, and is not pertinent to the operation of the tuning-fork vibrator assembly 150.

A description will be given of a production method for producing the tuning-fork vibrator assembly 150.

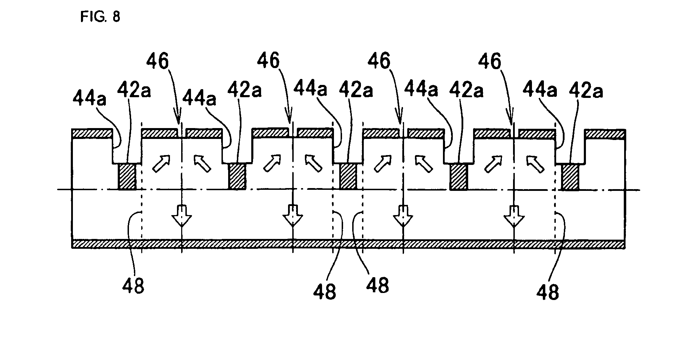

The production method for the tuning-fork vibrator assembly 150 includes the steps shown in FIGS. 4(a) to 4(d), and a polarized substrate 34 is formed. Subsequently, as shown in FIG. 8, split electrodes 28a and 28b are formed by cutting portions of a full-face electrode on one principal surface of the substrate 34 along center lines 46 between grooves 44a provided in the one principal surface. Then, the substrate 34 is cut at every other groove, as shown by dotted lines 48 shown in FIG. 8, so that a plurality of substrate pieces each having a center groove are formed. Each substrate piece thus obtained is cut at the groove so as to leave the portion located at one end side of the substrate piece. Consequently, two vibrators 50 and a connecting portion 60 are formed, and a tuning-fork vibrator assembly 150 can be obtained.

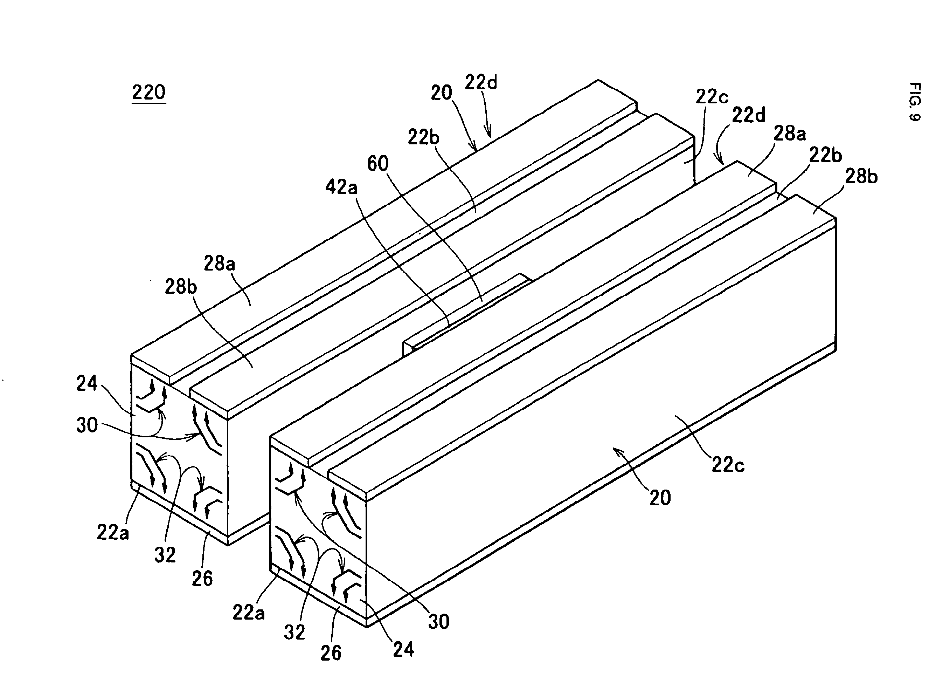

FIG. 9 is a perspective view illustrating an H-type vibrator assembly according to an embodiment of the present invention.

An H-type vibrator assembly 220 includes two vibrators 20 arranged side by side. These vibrators 20 are connected at the center by a connecting portion 60 so as to form an H-shape as a whole. The two vibrators 20 have a structure similar to that of the vibrator 20 shown in FIG. 1, and the connecting portion 60 is formed of the same material as that of the vibrating body 24 that constitutes the vibrator 20. Electrodes 42a and 42b are provided in opposite portions of the connecting portion 60, and extend along the two vibrators 20. The electrodes 42a and 42b are left in a production process for the H-type vibrator assembly 220, and are not pertinent to the operation of the H-type vibrator assembly 220.

A description will be given of a production method for the H-type vibrator assembly 220.

The production method for the H-type vibrator assembly 220 includes the steps shown in FIGS. 2(a) to 2(d), and a polarized substrate 34 is formed. Subsequently, as shown in FIG. 6, split electrodes 28a and 28b are formed by cutting portions of a full-face electrode on one principal surface of the substrate 24 along center lines 46 between grooves 44a provided in the one principal surface. Then, the substrate 34 is cut at every other groove, as shown by dotted lines 48 in FIG. 6, so that a plurality of substrate pieces each having s center groove are formed. Each substrate piece thus obtained is cut at the groove so as to leave the portion located at the center portion of the substrate piece. Consequently, two vibrators 20 and a connecting portion 60 are formed, and an H-type vibrator assembly 220 can be obtained.

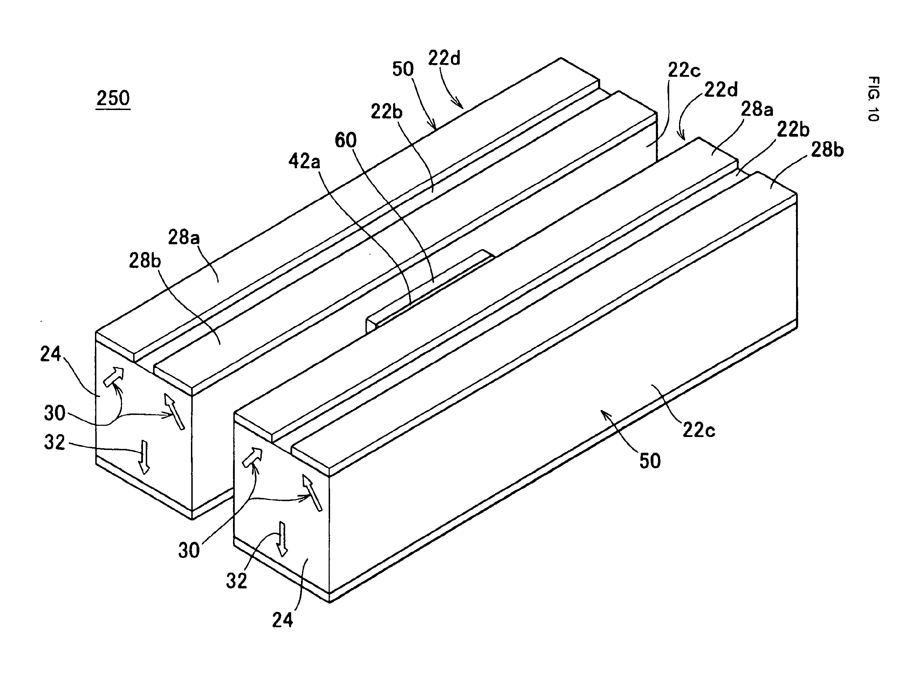

FIG. 10 is a perspective view illustrating an H-type vibrator assembly according to another embodiment of the present invention.

An H-type vibrator assembly 250 includes two vibrators 50 arranged side by side. These vibrators 50 are connected at the center by a connecting portion 60 so as to form an H-shape as a whole. The two vibrators 50 have a structure similar to that of the vibrator 50 shown in FIG. 3, and the connecting portion 60 is formed of the same material as that of the vibrating body 24 that constitutes the vibrator 50. An electrode 42a is provided in one of opposite portions of the connecting portion 60, and extends along the two vibrators 50. The electrode 42a is left in a production process for the H-type vibrator assembly 250, and is not pertinent to the operation of the H-type vibrator assembly 250.

A description will now be given of a production method for the H-type vibrator assembly 250.

The production method for the H-type vibrator assembly 250 includes the steps shown in FIGS. 4(a) to 4(d), and a polarized substrate 34 is formed. Subsequently, as shown in FIG. 8, split electrodes 28a and 28b are formed by cutting portions of a full-face electrode on one principal surface of the substrate 34 along center lines 46 between grooves 44a provided in the one principal surface. Then, the substrate 34 is cut at every other groove, as shown by dotted lines 48 in FIG. 8, so that a plurality of substrate pieces each having a center groove are formed. Each substrate piece thus obtained is cut at the groove so as to leave the portion located at the center portion of the substrate piece. Consequently, two vibrators 50 and a connecting portion 60 are formed, and an H-type vibrator assembly 250 can be obtained.

## Claims

1. A vibrator comprising:
a vibrating body (24) shaped like a quadrangular prism and having four side faces (22a, 22b, 22c, 22d) extending in a longitudinal direction;
a common electrode (26) provided on the entirety of one (22a) of the side faces (22a, 22b, 22c, 22d) of the vibrating body (24); and
split electrodes (28a, 28b) provided on the side face (22b) opposite to the side face (22a) on which the common electrode (26) is provided, the split electrodes (28a, 28b) being spaced from each other in a width direction,
**characterized in that** the vibrating body (24) includes a first polarized section (30) polarized in a direction from the side faces (22c, 22d) having no electrode toward the split electrodes (28a, 28b), and a second polarized section (32) polarized in a direction from the side faces (22c, 22d) having no electrode toward the common electrode (26).

2. A vibrator comprising:
a vibrating body (24) shaped like a quadrangular prism and having four side faces (22a, 22b, 22c, 22d) extending in a longitudinal direction;
a common electrode (26) provided on the entirety of one (22a) of the side faces (22a, 22b, 22c, 22d) of the vibrating body (24); and
split electrodes (28a, 28b) provided on the side face (22b) opposite to the side face (22a) on which the common electrode (26) is provided, the split electrodes (28a, 28b) being spaced in a width direction,
**characterized in that** the vibrating body (24) includes a first polarized section (30) polarized in a direction from the side faces (22c, 22d) having no electrode toward the split electrodes (28a, 28b), and a second polarized section (32) polarized in a direction from the split electrodes (28a, 28b) toward the common electrode (26) in a portion other than the first polarized section (30).

3. A tuning-fork vibrator assembly (120; 150) comprising:
two vibrators (20; 50) according to claim 1 or 2 that are arranged side by side and are connected by a connecting portion (60),
wherein the two vibrators (20; 50) are connected so that the split electrodes (28a, 28b) are provided on the same plane, and
wherein the connecting portion (60) is connected over an appropriate width to one-end portions of the two vibrators (20; 50).

4. An H-type vibrator assembly (220; 250) comprising:
two vibrators (20; 50) according to claim 1 or 2 that are arranged side by side and are connected by a connecting portion (60),
wherein the two vibrators (20; 50) are connected so that the split electrodes (28a, 28b) are provided on the same plane, and
wherein the connecting portion (60) is connected over an appropriate width to almost the centers of the two vibrators (20; 50).

5. A vibrator production method comprising:
a first step of forming an electrode (36, 38) on each of one principal surface and the other principal surface of a substrate (34);
a second step of forming grooves (40a, 40b) at regular intervals in the one principal surface and the other principal surface of the substrate (34);
a third step of forming electrodes in (42a, 42b) the grooves (40a, 40b);
a fourth step of forming additional grooves (44a, 44b) in the grooves (40a, 90b), the additional grooves (44a, 44b) being shallower and wider than the grooves (40a, 40b);
a fifth step of applying a voltage between the electrodes (42a) formed in the grooves (40a) of the one principal surface and the electrode (36) formed on the one principal surface, and between the electrodes (42b) formed in the grooves (40b) of the other principal surface and the electrode (38) formed on the other principal surface so as to produce polarization from the electrodes (42a) formed in the grooves (40a) of the one principal surface toward the one principal surface and to produce polarization from the electrodes (42b) formed in the grooves (40b) of the other principal surface toward the other principal surface;
a sixth step of forming split electrodes (28a, 28b) on the one principal surface; and
a seventh step of cutting the substrate (34) at the grooves (40a, 40b).

6. A vibrator production method comprising:
a first step of forming an electrode (36, 38) on each of one principal surface and the other principal surface of a substrate (34);
a second step of polarizing the substrate (34) from the one principal surface toward the other principal surface;
a third step of forming grooves (40a) at regular intervals in the one principal surface of the substrate (34);
a fourth step of forming electrodes (42a) in the grooves (40a);
a fifth step of forming additional grooves (44a) in the grooves (40a), the additional grooves (44a) being shallower and wider than the grooves (40a);
a sixth step of applying a voltage between the electrodes (42a) formed in the grooves (40a) of the one principal surface and the electrode (36) formed on the one principal surface so as to produce polarization from the electrodes (42a) formed in the grooves (40a) toward the one principal surface;
a seventh step of forming split electrodes (28a, 28b) on the one principal surface; and
an eighth step of cutting the substrate (34) at the grooves (40a).

7. A tuning-fork vibrator assembly production method comprising:
a first step of forming an electrode (36, 38) on each of one principal surface and the other principal surface of a substrate (34);
a second step of forming grooves (40a, 40b) at regular intervals in the one principal surface and the other principal surface of the substrate (34);
a third step of forming electrodes (42a, 42b) in the grooves (40a, 40b);
a fourth step of forming additional grooves (44a, 44b) in the grooves (40a, 40b), the additional grooves (44a, 44b) being shallower and wider than the grooves (40a, 40b);
a fifth step of applying a voltage between the electrodes formed (42a) in the grooves (40a) of the one principal surface and the electrode (36) formed on the one principal surface, and between the electrodes (42b) formed in the grooves (40b) of the other principal surface and the electrode (38) formed on the other principal surface so as to produce polarization from the electrodes (42a) formed in the grooves (40a) of the one principal surface toward the one principal surface and to produce polarization from the electrodes (42b) formed in the grooves (40b) of the other principal surface toward the other principal surface;
a sixth step of forming split electrodes (28a, 28b) on the one principal surface;
a seventh step of cutting the substrate (34) at every other groove (40a, 40b) so as to form substrate pieces; and
an eighth step of cutting each of the substrate pieces at the groove (40a, 40b) with one-end portion thereof being left so that two vibrators (20; 50) and a connecting portion (60) for connecting one-end portions of the two vibrators (20; 50) are formed.

8. A tuning-fork vibrator assembly production method comprising:
a first step of forming an electrode (36, 38) on each of one principal surface and the other principal surface of a substrate (34);
a second step of polarizing the substrate (34) from the one principal surface toward the other principal surface;
a third step of forming grooves (40a) at regular intervals in the one principal surface of the substrate (34);
a fourth step of forming electrodes (42a) in the grooves (40a);
a fifth step of forming additional grooves (44a) in the grooves (40a), the additional grooves (44a) being shallower and wider than the grooves (40a);
a sixth step of applying a voltage between the electrodes (42a) formed in the grooves (40a) of the one principal surface and the electrode (36) formed on the one principal surface so as to produce polarization from the electrodes (42a) formed in the grooves (40a) toward the one principal surface;
a seventh step of forming split electrodes (28a, 28b) on the one principal surface;
an eighth step of cutting the substrate (34) at every other groove (40a) so as to form substrate pieces; and
a ninth step of cutting each of the substrate pieces at the groove (40a) with one-end portion thereof being left so that two vibrators (20; 50) and a connecting portion (60) for connecting one-end portions of the two vibrators (20; 50) are formed.

9. An H-type vibrator assembly production method comprising:
a first step of forming an electrode (36, 38) on each of one principal surface and the other principal surface of a substrate (34);
a second step of forming grooves (40a, 40b) at regular intervals in the one principal surface and the other principal surface of the substrate (34);
a third step of forming electrodes (42a, 42b) in the grooves (40a, 40b);
a fourth step of forming additional grooves (44a, 44b) in the grooves (40a, 40b), the additional grooves (44a, 44b) being shallower and wider than the grooves (40a, 40b);
a fifth step of applying a voltage between the electrodes (42a) formed in the grooves (40a) of the one principal surface and the electrode (36) formed on the one principal surface, and between the electrodes (42b) formed in the grooves (40b) of the other principal surface and the electrode (38) formed on the other principal surface so as to produce polarization from the electrodes (42a) formed in the grooves (40a) of the one principal surface toward the one principal surface and to produce polarization from the electrodes (42b) formed in the grooves (40b) of the other principal surface toward the other principal surface;
a sixth step of forming split electrodes (28a, 28b) on the one principal surface;
a seventh step of cutting the substrate (34) at every other groove (40a, 40b) so as to form substrate pieces; and
an eighth step of cutting each of the substrate pieces at the groove (40a, 40b) with a center portion thereof being left so that two vibrators (20; 50) and a connecting portion (60) for connecting the centers of the two vibrators (20; 50) are formed.

10. An H-type vibrator assembly production comprising:
a first step of forming an electrode (36, 38) on each of one principal surface and the other principal surface of a substrate (34);
a second step of polarizing the substrate (34) from the one principal surface toward the other principal surface;
a third step of forming grooves (40a) at regular intervals in the one principal surface of the substrate (34);
a fourth step of forming electrodes (42a) in the grooves (40a);
a fifth step of forming additional grooves (44a) in the grooves (40a), the additional grooves (44a) being shallower and wider than the grooves (40a);
a sixth step of applying a voltage between the electrodes (42a) formed in the grooves (40a) of the one principal surface and the electrode (36) formed on the one principal surface so as to produce polarization from the electrodes (42a) formed in the grooves (40a) toward the one principal surface;
a seventh step of forming split electrodes (28a, 28b) on the one principal surface;
an eighth step of cutting the substrate (34) at every other groove (40a) so as to form substrate pieces; and
a ninth step of cutting each of the substrate pieces at the groove (40a) with a center portion thereof being left so that two vibrators (20; 50) and a connecting portion (60) for connecting the centers of the two vibrators (20; 50) are formed.

## Patentansprüche

1. Ein Schwingelement, das folgende Merkmale aufweist:
einen Schwingkörper (24), der wie ein viereckiges Prisma geformt ist und vier Seitenflächen (22a, 22b, 22c, 22d) aufweist, die sich in einer Längsrichtung erstrecken;
eine gemeinsame Elektrode (26), die auf der Gesamtheit von einer (22a) der Seitenflächen (22a, 22b, 22c, 22d) des Schwingkörpers (24) vorgesehen ist; und
geteilte Elektroden (28a, 28b), die auf der Seitenfläche (22b) gegenüber der Seitenfläche (22a), auf der die gemeinsame Elektrode (26) vorgesehen ist, vorgesehen sind, wobei die geteilten Elektroden (28a, 28b) in einer Breiterichtung voneinander beabstandet sind,
**dadurch gekennzeichnet, dass** der Schwingkörper (24) einen ersten polarisierten Abschnitt (30) umfasst, der in einer Richtung von den Seitenflächen (22c, 22d), die keine Elektrode aufweisen, zu den geteilten Elektroden (28a, 28b) hin polarisiert ist, und einen zweiten polarisierten Abschnitt (32), der in einer Richtung von den Seitenflächen (22c, 22d), die keine Elektrode aufweisen, zu der gemeinsamen Elektrode (26) hin polarisiert ist.

2. Ein Schwingelement, das folgende Merkmale aufweist:
einen Schwingkörper (24), der wie ein viereckiges Prisma geformt ist und vier Seitenflächen (22a, 22b, 22c, 22d) aufweist, die sich in einer Längsrichtung erstrecken;
eine gemeinsame Elektrode (26), die auf der Gesamtheit von einer (22a) der Seitenflächen (22a, 22b, 22c, 22d) des Schwingkörpers (24) vorgesehen ist; und
geteilte Elektroden (28a, 28b), die auf der Seitenfläche (22b) gegenüber der Seitenfläche (22a), auf der die gemeinsame Elektrode (26) vorgesehen ist, vorgesehen sind, wobei die geteilten Elektroden (28a, 28b) in einer Breiterichtung beabstandet sind,
**dadurch gekennzeichnet, dass** der Schwingkörper (24) einen ersten polarisierten Abschnitt (30) umfasst, der in einer Richtung von den Seitenflächen (22a, 22b, 22c, 22d), die keine Elektrode aufweisen, zu den geteilten Elektroden (28a, 28b) hin polarisiert ist, und einen zweiten polarisierten Abschnitt (32), der in einer Richtung von den geteilten Elektroden (28a, 28b) zu der gemeinsamen Elektrode (26) hin polarisiert ist, in einem anderen Abschnitt als dem ersten polarisierten Abschnitt (30).

3. Eine Stimmgabel-Schwingelementanordnung (120; 150), die folgende Merkmale aufweist:
zwei Schwingelemente (20; 50) gemäß Anspruch 1 oder 2, die Seite an Seite angeordnet sind und durch einen Verbindungsabschnitt (60) verbunden sind,
wobei die zwei Schwingelemente (20; 50) verbunden sind, so dass die geteilten Elektroden (28a, 28b) auf der gleichen Ebene vorgesehen sind, und
wobei der Verbindungsabschnitt (60) über eine geeignete Breite mit Ein-Ende-Abschnitten der zwei Schwingelemente (20; 50) verbunden ist.

4. Eine H-Typ-Schwingelementanordnung (220; 250), die folgende Merkmale aufweist:
zwei Schwingelemente (20; 50) gemäß Anspruch 1 oder 2, die Seite an Seite angeordnet sind und durch einen Verbindungsabschnitt (60) verbunden sind,
wobei die zwei Schwingelemente (20; 50) verbunden sind, so dass die geteilten Elektroden (28a, 28b) auf der gleichen Ebene vorgesehen sind, und
wobei der Verbindungsabschnitt (60) über eine geeignete Breite mit beinahe den Mitten der zwei Schwingelemente (20; 50) verbunden ist.

5. Ein Schwingelementherstellungsverfahren, das folgende Schritte aufweist:
einen ersten Schritt des Bildens einer Elektrode (36, 38) auf jeder einer Hauptoberfläche und der anderen Hauptoberfläche eines Substrats (34);
einen zweiten Schritt des Bildens von Rillen (40a, 40b) in regelmäßigen Abständen in der einen Hauptoberfläche und der anderen Hauptoberfläche des Substrats (34);
einen dritten Schritt des Bildens von Elektroden (42a, 42b) in den Rillen (40a, 40b);
einen vierten Schritt des Bildens zusätzlicher Rillen (44a, 44b) in den Rillen (40a, 40b), wobei die zusätzlichen Rillen (44a, 44b) flacher und breiter sind als die Rillen (40a, 40b);
einen fünften Schritt des Anlegens einer Spannung zwischen die Elektroden (42a), die in den Rillen (40a) der einen Hauptoberfläche gebildet sind, und die Elektrode (36), die auf der einen Hauptoberfläche gebildet ist, und zwischen die Elektroden (42b), die in den Rillen (40b) der anderen Hauptoberfläche gebildet sind, und die Elektrode (38), die auf der anderen Hauptoberfläche gebildet ist, um Polarisation von den Elektroden (42a), die in den Rillen (40a) der einen Hauptoberfläche gebildet sind, zu der einen Hauptoberfläche hin zu erzeugen, und um Polarisation von den Elektroden (42b), die in den Rillen (40b) der anderen Hauptoberfläche gebildet sind, zu der anderen Hauptoberfläche hin zu erzeugen;
einen sechsten Schritt des Bildens geteilter Elektroden (28a, 28b) auf der einen Hauptoberfläche; und
einen siebten Schritt des Schneidens des Substrats (34) an den Rillen (40a, 40b).

6. Ein Schwingelementherstellungsverfahren, das folgende Schritte aufweist:
einen ersten Schritt des Bildens einer Elektrode (36, 38) auf jeder einer Hauptoberfläche und der anderen Hauptoberfläche eines Substrats (34);
einen zweiten Schritt des Polarisierens des Substrats (34) von der einen Hauptoberfläche zu der anderen Hauptoberfläche hin;
einen dritten Schritt des Bildens von Rillen (40a) in regelmäßigen Abständen in der einen Hauptoberfläche des Substrats (34);
einen vierten Schritt des Bildens von Elektroden (42a) in den Rillen (40a);
einen fünften Schritt des Bildens zusätzlicher Rillen (44a) in den Rillen (40a), wobei die zusätzlichen Rillen (44a) flacher und breiter sind als die Rillen (40a);
einen sechsten Schritt des Anlegens einer Spannung zwischen die Elektroden (42a), die in den Rillen (40a) der einen Hauptoberfläche gebildet sind, und die Elektrode (36), die auf der einen Hauptoberfläche gebildet ist, um Polarisation von den Elektroden (42a), die in den Rillen (40a) gebildet sind, zu der einen Hauptoberfläche hin zu erzeugen;
einen siebten Schritt des Bildens geteilter Elektroden (28a, 28b) auf der einen Hauptoberfläche; und
einen achten Schritt des Schneidens des Substrats (34) an den Rillen (40a).

7. Ein Stimmgabel-Schwingelementanordnung-Herstellungsverfahren, das folgende Schritte aufweist:
einen ersten Schritt des Bildens einer Elektrode (36, 38) auf jeder einer Hauptoberfläche und der anderen Hauptoberfläche eines Substrats (34);
einen zweiten Schritt des Bildens von Rillen (40a, 40b) in regelmäßigen Abständen in der einen Hauptoberfläche und der anderen Hauptoberfläche des Substrats (34);
einen dritten Schritt des Bildens von Elektroden (42a, 42b) in den Rillen (40a, 40b);
einen vierten Schritt des Bildens zusätzlicher Rillen (44a, 44b) in den Rillen (40a, 40b), wobei die zusätzlichen Rillen (44a, 44b) flacher und breiter sind als die Rillen (40a, 40b);
einen fünften Schritt des Anlegens einer Spannung zwischen die Elektroden (42a), die in den Rillen (40a) der einen Hauptoberfläche gebildet sind, und die Elektrode (36), die auf der einen Hauptoberfläche gebildet ist, und zwischen die Elektroden (42b), die in den Rillen (40b) der anderen Hauptoberfläche gebildet sind, und die Elektrode (38), die auf der anderen Hauptoberfläche gebildet ist, um Polarisation von den Elektroden (42a), die in den Rillen (40a) der einen Hauptoberfläche gebildet sind, zu der einen Hauptoberfläche hin zu erzeugen, und um Polarisation von den Elektroden (42b), die in den Rillen (40b) der anderen Hauptoberfläche gebildet sind, zu der anderen Hauptoberfläche hin zu erzeugen;
einen sechsten Schritt des Bildens geteilter Elektroden (28a, 28b) auf der einen Hauptoberfläche;
einen siebten Schritt des Schneidens des Substrats an jeder zweiten Rille (40a, 40b), um Substratstücke zu bilden; und
einen achten Schritt des Schneidens von jedem der Substratstücke an der Rille (40a, 40b), wobei ein Ein-Ende-Abschnitten davon übrigbleibt, so dass zwei Schwingelemente (20; 50) und ein Verbindungsabschnitt (60) zum Verbinden von Ein-Ende-Abschnitten der zwei Schwingelemente (20; 50) gebildet werden.

8. Ein Stimmgabel-Schwingelementanordnung-Herstellungsverfahren, das folgende Schritte aufweist:
einen ersten Schritt des Bildens einer Elektrode (36, 38) auf jeder einer Hauptoberfläche und der anderen Hauptoberfläche eines Substrats (34);
einen zweiten Schritt des Polarisierens des Substrats (34) von der einen Hauptoberfläche zu der anderen Hauptoberfläche hin;
einen dritten Schritt des Bildens von Rillen (40a) in regelmäßigen Abständen in der einen Hauptoberfläche des Substrats (34);
einen vierten Schritt des Bildens von Elektroden (42a) in den Rillen (40a);
einen fünften Schritt des Bildens zusätzlicher Rillen (44a) in den Rillen (40a), wobei die zusätzlichen Rillen (44a) flacher und breiter sind als die Rillen (40a);
einen sechsten Schritt des Anlegens einer Spannung zwischen die Elektroden (42a), die in den Rillen (40a) der einen Hauptoberfläche gebildet sind, und die Elektrode (36), die auf der einen Hauptoberfläche gebildet ist, um Polarisation von den Elektroden (42), die in den Rillen (40a) gebildet sind, zu der einen Hauptoberfläche hin zu erzeugen;
einen siebten Schritt des Bildens geteilter Elektroden (28a, 28b) auf der einen Hauptoberfläche;
einen achten Schritt des Schneidens des Substrats (34) an jeder zweiten Rille (40a), um Substratstücke zu bilden; und
einen neunten Schritt des Schneidens von jedem der Substratstücke an der Rille (40a), wobei ein Ein-Ende-Abschnitt davon übrigbleibt, so dass zwei Schwingelemente (20; 50) und ein Verbindungsabschnitt (60) zum Verbinden von Ein-Ende-Abschnitten der zwei Schwingelemente (20; 50) gebildet werden.

9. Ein H-Typ-Schwingelementanordnung-Herstellungsverfahren, das folgende Schritte aufweist:
einen ersten Schritt des Bildens einer Elektrode (36, 38) auf jeder einer Hauptoberfläche und der anderen Hauptoberfläche eines Substrats (34);
einen zweiten Schritt des Bildens von Rillen (40a, 40b) in regelmäßigen Abständen in der einen Hauptoberfläche und der anderen Hauptoberfläche des Substrats (34);
einen dritten Schritt des Bildens von Elektroden (42a, 42b) in den Rillen (40a, 40b);
einen vierten Schritt des Bildens zusätzlicher Rillen (44a, 44b) in den Rillen (40a, 40b), wobei die zusätzlichen Rillen (44a, 44b) flacher und breiter sind als die Rillen (40a, 40b);
einen fünften Schritt des Anlegens einer Spannung zwischen die Elektroden (42a), die in den Rillen (40a) der einen Hauptoberfläche gebildet sind, und die Elektrode (38), die auf der einen Hauptoberfläche gebildet ist, und zwischen die Elektroden (42b), die in den Rillen (40b) der anderen Hauptoberfläche gebildet sind, und die Elektrode (38), die auf der anderen Hauptoberfläche gebildet ist, um Polarisation von den Elektroden (42a), die in den Rillen (40a) der einen Hauptoberfläche gebildet sind, zu der einen Hauptoberfläche hin zu erzeugen, und um Polarisation von den Elektroden (42b), die in den Rillen (40b) der anderen Hauptoberfläche gebildet sind, zu der anderen Hauptoberfläche hin zu erzeugen;
einen sechsten Schritt des Bildens geteilter Elektroden (28a, 28b) auf der einen Hauptoberfläche;
einen siebten Schritt des Schneidens des Substrats (34) an jeder zweiten Rille (40a, 40b), um Substratstücke zu bilden; und
einen achten Schritt des Schneidens von jedem der Substratstücke an der Rille (40a, 40b), wobei ein Mittelabschnitt davon übrigbleibt, so dass zwei Schwingungselemente (20; 50) und ein Verbindungsabschnitt (60) zum Verbinden der Mitten der zwei Schwingungselemente (20; 50) gebildet werden.

10. Eine H-Typ-Schwingungselementanordnungsherstellung, die folgende Schritte aufweist:
einen ersten Schritt des Bildens einer Elektrode (36, 38) auf jeder einer Hauptoberfläche und der anderen Hauptoberfläche eines Substrats (34);
einen zweiten Schritt des Polarisierens des Substrats (34) von der einen Hauptoberfläche zu der anderen Hauptoberfläche hin;
einen dritten Schritt des Bildens von Rillen (40a) in regelmäßigen Abständen in der einen Hauptoberfläche des Substrats (34);
einen vierten Schritt des Bildens von Elektroden (42a) in den Rillen (40a);
einen fünften Schritt des Bildens zusätzlicher Rillen (44a) in den Rillen (40a), wobei die zusätzlichen Rillen (44a) flacher und breiter sind als die Rillen (40a);
einen sechsten Schritt des Anlegens einer Spannung zwischen die Elektroden (42a), die in den Rillen (40a) der einen Hauptoberfläche gebildet sind, und die Elektrode (36), die auf der einen Hauptoberfläche gebildet ist, um Polarisation von den Elektroden (42a), die in den Rillen (40a) gebildet sind, zu der einen Hauptoberfläche hin zu erzeugen;
einen siebten Schritt des Bildens geteilter Elektroden (28a, 28b) auf der einen Hauptoberfläche;
einen achten Schritt des Schneidens des Substrats (34) an jeder zweiten Rille (40a), um Substratstücke zu bilden;
einen neunten Schritt des Schneidens von jedem der Substratstücke an der Rille (40a), wobei ein Mittelabschnitt davon übrigbleibt, so dass zwei Schwingungselemente (20; 50) und ein Verbindungsabschnitt (60) zum Verbinden der Mitten der zwei Schwingelemente (20; 50) gebildet werden.

## Revendications

1. Vibreur comprenant :
un corps vibrant (24) en forme de prisme quadrangulaire et ayant quatre faces latérales (22a, 22b, 22c, 22d) s'étendant dans une direction longitudinale ;
une électrode commune (26) formée sur la totalité de l'une (22a) des faces latérales (22a, 22b, 22c, 22d) du corps vibrant (24) ; et
des électrodes séparées (28a, 28b) formées sur la face latérale (22b) opposée à la face latérale (22a) sur laquelle est formée l'électrode commune (26), les électrodes séparées (28a, 28b) étant espacées l'une de l'autre dans le sens de la largeur,
**caractérisé en ce que** le corps vibrant (24) comprend une première section polarisée (30) polarisée dans une direction allant des faces latérales (22c, 22d) sans électrode vers les électrodes séparées (28a, 28b), et une deuxième section polarisée (32) polarisée dans une direction allant des faces latérale (22c, 22d) sans électrode vers l'électrode commune (26).

2. Vibreur comprenant :
un corps vibrant (24) en forme de prisme quadrangulaire et ayant quatre faces latérales (22a, 22b, 22c, 22d) s'étendant dans une direction longitudinale ;
une électrode commune (26) formée sur la totalité de l'une (22a) des faces latérales (22a, 22b, 22c, 22d) du corps vibrant (24) ; et
des électrodes séparées (28a, 28b) formées sur la face latérale (22b) opposée à la face latérale (22a) sur laquelle est formée l'électrode commune (26), les électrodes séparées (28a, 28b) étant espacées l'une de l'autre dans le sens de la largeur,
**caractérisé en ce que** le corps vibrant (24) comprend une première section polarisée (30) polarisée dans une direction allant des faces latérales (22c, 22d) sans électrode vers les électrodes séparées (28a, 28b), et une deuxième section polarisée (32) polarisée dans une direction allant des électrodes séparées (28a, 28b) vers l'électrode commune (26) dans une partie autre que la première section polarisée (30).

3. Ensemble vibreur en forme de diapason (120 ; 150) comprenant :
deux vibreurs (20 ; 50) selon la revendication 1 ou 2, qui sont disposés côte-à-côte et qui sont raccordés par une partie de raccordement (60),
dans lequel les deux vibreurs (20 ; 50) sont raccordés de telle sorte que les électrodes séparées (28a, 28b) soient formées sur le même plan, et
dans lequel la partie de raccordement (60) est raccordée, sur une largeur appropriée, à des parties de première extrémité des deux vibreurs (20 ; 50).

4. Ensemble de vibreurs en H (220 ; 250) comprenant :
deux vibreurs (20 ; 50) selon la revendication 1 ou 2, qui sont disposés côte-à-côte et qui sont raccordés par une partie de raccordement (60),
dans lequel les deux vibreurs (20 ; 50) sont raccordés de telle sorte que les électrodes séparées (28a, 28b) soient formées sur le même plan, et
dans lequel la partie de raccordement (60) est raccordés, sur une largeur appropriée, approximativement aux centres des deux vibreurs (20 ; 50).

5. Procédé de production d'un vibreur comprenant :
une première étape de formation d'une électrode (36, 38) sur chacune d'une première surface principale et de l'autre surface principale d'un substrat (34) ;
une deuxième étape de formation de rainures (40a, 40b) à intervalles réguliers dans la première surface principale et dans l'autre surface principale du substrat (34) ;
une troisième étape de formation d'électrodes (42a, 42b) dans les rainures (40a, 40b) ;
une quatrième étape de formation de rainures additionnelles (44a, 44b) dans les rainures (40a, 40b), les rainures additionnelles (44a, 44b) étant moins profondes et plus larges que les rainures (40a, 40b) ;
une cinquième étape d'application d'une tension entre les électrodes (42a) formées dans les rainures (40a) de la première surface principale et l'électrode (36) formée sur la première surface principale, et entre les électrodes (42b) formées dans les rainures (40b) de l'autre surface principale et l'électrode (38) formée sur l'autre surface principale, de façon à produire une polarisation allant des électrodes (42a) formées dans les rainures (40a) de la première surface principale vers la première surface principale et à produire une polarisation allant des électrodes (42b) formées dans les rainures (40b) de l'autre surface principale vers l'autre surface principale ;
une sixième étape de formation d'électrodes séparées (28a, 28b) sur la première surface principale ; et
une septième étape de découpage du substrat (34) au niveau des rainures (40a, 40b).

6. Procédé de production d'un vibreur comprenant :
une première étape de formation d'une électrode (36, 38) sur chacune d'une première surface principale et de l'autre surface principale d'un substrat (34) ;
une deuxième étape de polarisation du substrat (34) de la première surface principale vers l'autre surface principale ;
une troisième étape de formation de rainures (40a) à intervalles réguliers dans la première surface principale du substrat (34) ;
une quatrième étape de formation d'électrodes (42a) dans les rainures (40a) ;
une cinquième étape de formation de rainures additionnelles (44a) dans les rainures (40a), les rainures additionnelles (44a) étant moins profondes et plus larges que les rainures (40a) ;
une sixième étape d'application d'une tension entre les électrodes (42a) formées dans les rainures (40a) de la première surface principale et l'électrode (36) formée sur la première surface principale, de façon à produire une polarisation allant des électrodes (42a) formées dans les rainures (40a) vers la première surface principale ;
une septième étape de formation d'électrodes séparées (28a, 28b) sur la première surface principale ; et
une huitième étape de découpage du substrat (34) au niveau des rainures (40a).

7. Procédé de production d'ensemble vibreur en forme de diapason comprenant :
une première étape de formation d'une électrode (36, 38) sur chacune d'une première surface principale et de l'autre surface principale d'un substrat (34) ;
une deuxième étape de formation de rainures (40a, 40b) à intervalles réguliers dans la première surface principale et dans l'autre surface principale du substrat (34) ;
une troisième étape de formation d'électrodes (42a, 42b) dans les rainures (40a, 40b) ;
une quatrième étape de formation de rainures additionnelles (44a, 44b) dans les rainures (40a, 40b), les rainures additionnelles (44a, 44b) étant moins profondes et plus larges que les rainures (40a, 40b) ;
une cinquième étape d'application d'une tension entre les électrodes (42a) formées dans les rainures (40a) de la première surface principale et l'électrode (36) formée sur la première surface principale, et entre les électrodes (42b) formées dans les rainures (40b) de l'autre surface principale et l'électrode (38) formée sur l'autre surface principale, de façon à produire une polarisation allant des électrodes (42a) formées dans les rainures (40a) de la première surface principale vers la première surface principale et à produire une polarisation allant des électrodes (42b) formées dans les rainures (40b) de l'autre surface principale vers l'autre surface principale ;
une sixième étape de formation d'électrodes séparées (28a, 28b) sur la première surface principale ;
une septième étape de découpage du substrat (34) au niveau d'une rainure (40a, 40b) sur deux, de façon à former des morceaux de substrat ; et
une huitième étape de découpage de chacun des morceaux de substrat au niveau de la rainure (40a, 40b) en laissant une partie de première extrémité de celle-ci, de telle sorte que soient formés deux vibreurs (20 ; 50) et une partie de raccordement (60) pour le raccordement des parties de première extrémité des deux vibreurs (20 ; 50).

8. Procédé de production d'ensemble vibreur en forme de diapason comprenant :
une première étape de formation d'une électrode (36, 38) sur chacune d'une première surface principale et de l'autre surface principale d'un substrat (34) ;
une deuxième étape de polarisation du substrat (34) de la première surface principale vers l'autre surface principale ;
une troisième étape de formation de rainures (40a) à intervalles réguliers dans la première surface principale du substrat (34) ;
une quatrième étape de formation d'électrodes (42a) dans les rainures (40a) ;
une cinquième étape de formation de rainures additionnelles (44a) dans les rainures (40a), les rainures additionnelles (44a) étant moins profondes et plus larges que les rainures (40a) ;
une sixième étape d'application d'une tension entre les électrodes (42a) formées dans les rainures (40a) de la première surface principale et l'électrode (36) formée sur la première surface principale, de façon à produire une polarisation allant des électrodes (42a) formées dans les rainures (40a) vers la première surface principale ;
une septième étape de formation d'électrodes séparées (28a, 28b) sur la première surface principale ;
une huitième étape de découpage du substrat (34) au niveau d'une rainure (40a) sur deux, de façon à former des morceaux de substrat ; et
une neuvième étape de découpage de chacun des morceaux de substrat au niveau de la rainure (40a) en laissant une partie de première extrémité de celle-ci, de telle sorte que soient formés deux vibreurs (20 ; 50) et une partie de raccordement (60) pour le raccordement des parties de première extrémité des deux vibreurs (20 ; 50).

9. Procédé de production d'ensemble vibreur en H comprenant :
une première étape de formation d'une électrode (36, 38) sur chacune d'une première surface principale et de l'autre surface principale d'un substrat (34) ;
une deuxième étape de formation de rainures (40a, 40b) à intervalles réguliers dans la première surface principale et dans l'autre surface principale du substrat (34) ;
une troisième étape de formation d'électrodes (42a, 42b) dans les rainures (40a, 40b) ;
une quatrième étape de formation de rainures additionnelles (44a, 44b) dans les rainures (40a, 40b), les rainures additionnelles (44a, 44b) étant moins profondes et plus larges que les rainures (40a, 40b) ;
une cinquième étape d'application d'une tension entre les électrodes (42a) formées dans les rainures (40a) de la première surface principale et l'électrode (36) formée sur la première surface principale, et entre les électrodes (42b) formées dans les rainures (40b) de l'autre surface principale et l'électrode (3 8) formée sur l'autre surface principale, de façon à produire une polarisation allant des électrodes (42a) formées dans les rainures (40a) de la première surface principale vers la première surface principale et à produire une polarisation allant des électrodes (42b) formées dans les rainures (40b) de l'autre surface principale vers l'autre surface principale ;
une sixième étape de formation d'électrodes séparées (28a, 28b) sur la première surface principale ;
une septième étape de découpage du substrat (34) au niveau d'une rainure (40a, 40b) sur deux, de façon à former des morceaux de substrat ; et
une huitième étape de découpage de chacun des morceaux de substrat au niveau de la rainure (40a, 40b) en laissant une partie centrale de celle-ci, de telle sorte que soient formés deux vibreurs (20 ; 50) et une partie de raccordement (60) pour le raccordement des centres des deux vibreurs (20 ; 50).

10. Procédé de production d'ensemble vibreur en H comprenant :
une première étape de formation d'une électrode (36, 38) sur chacune d'une première surface principale et de l'autre surface principale d'un substrat (34) ;
une deuxième étape de polarisation du substrat (34) de la première surface principale vers l'autre surface principale ;
une troisième étape de formation de rainures (40a) à intervalles réguliers dans la première surface principale du substrat (34) ;
une quatrième étape de formation d'électrodes (42a) dans les rainures (40a) ;
une cinquième étape de formation de rainures additionnelles (44a) dans les rainures (40a), les rainures additionnelles (44a) étant moins profondes et plus larges que les rainures (40a) ;
une sixième étape d'application d'une tension entre les électrodes (42a) formées dans les rainures (40a) de la première surface principale et l'électrode (36) formée sur la première surface principale, de façon à produire une polarisation allant des électrodes (42a) formées dans les rainures (40a) vers la première surface principale ;
une septième étape de formation d'électrodes séparées (28a, 28b) sur la première surface principale ;
une huitième étape de découpage du substrat (34) au niveau d'une rainure (40a) sur deux, de façon à former des morceaux de substrat ; et
une neuvième étape de découpage de chacun des morceaux de substrat au niveau de la rainure (40a) en laissant une partie centrale de celle-ci, de telle sorte que soient formés deux vibreurs (20 ; 50) et une partie de raccordement (60) pour le raccordement des centres des deux vibreurs (20 ; 50).
